# EUROPEAN PATENT APPLICATION

(11) **EP 2 299 490 A2**
(43) Date of publication of application: **23.03.2011**
(21) Application number: 10006435.1
(22) Date of filing: 21.06.2010
(51) Int. Cl.: H01L 27/02, H01L 27/06, H01L 21/20

(54) **A semiconductor device comprising a honeycomb heteroepitaxy**

(30) Priority: 18.09.2009 US 562852
(71) Applicant: Taiwan Semiconductor Manufacturing Company, Ltd., Hsin-Chu, 300-77 (TW)
(72) Inventor: Passlack, Matthias, 3060 Bertem (BE)
(74) Representative: TER MEER - STEINMEISTER & PARTNER GbR

(57) **Abstract**

A semiconductor device comprising a honeycomb heteroepitaxy and method for making same are described. One embodiment is a method comprising defining a mask on a silicon substrate, the mask comprising a plurality of nano-size openings therethrough; subsequent to the defining, creating essentially defect-free non-silicon semiconductor nano-islands on portions of a surface of the silicon substrate exposed through the mask openings; subsequent to the creating, depositing high-k gate dielectric is deposited on the nano-islands; and subsequent to the deposition, constructing transistors on the nano-islands.

## Description

### BACKGROUND

Silicon CMOS technology has dominated digital circuitry, such as microprocessors, for the last several decades. However, with critical feature sizes approaching 22 nm and less, performance advantages from further size scaling appear to be diminishing for silicon channels. To continue driving performance enhancements, high-mobility materials, such as indium gallium arsenide (InGaAs), indium arsenide antimonide (InAsSb), and germanium (Ge), are replacing silicon as channel materials. However, such high-mobility materials are incompatible with silicon in terms of crystal structure, lattice constant, thermal expansion coefficient, and other parameters. This incompatibility gives rise to defects that degrade material properties, device performance and reliability, and circuit yield.

Two distinctively different approaches are described in the prior art for reducing defect density in heterogeneous epitaxy of lattice mismatched systems. One approach uses blanket films, or buffer layers, of typically ternary or quaternary semiconductors. Defects (in particular, threading dislocations) are trapped or terminated to a certain extent within the buffer layer. The other approach uses trapping or termination of defects arising from lattice mismatch on sidewalls of a patterned mask, which mask typically comprises a dielectric. In this technique, the epitaxial lattice mismatched material is grown to a thickness at which it laterally extends over the mask. In general, the number of threading dislocations decreases in density with increasing distance from the surface of the substrate for both techniques. Disadvantages of such prior art techniques include the need for relatively thick buffer layers that typically exceed 0.5 - 1 µm in thickness and relatively high remaining threading dislocation densities, typically in the range of 10⁵ to 10⁶ cm⁻² or higher at or in the vicinity of the surface. Buffer layers of this thickness are not compatible with CMOS planarity and manufacturing requirements and are further unsuitable for efficient heat removal, a paramount requirement of typical CMOS microprocessors dissipating upwards of 100-300 watts of heat. Specific heat conductivity of such ternary or quaternary materials is typically an order of magnitude or more inferior to silicon.

The prior art further describes heteroepitaxial growth of lattice mismatched, dislocation-free nanowires on silicon substrate. Such nanowires have a typical height on the order of 5-10 µm. For example, dislocation-free InAs nanowires are nucleated on unpatterned silicon substrate using a nucleation template, such as gold (Au) or self-assembled organic coatings, and grow with a typical diameter of 50 nm, although they can grow to a diameter as large as 150 nm (T. Martensson et al., Advanced Materials 2007, 19, 1801-1806). Nanowire MOSFETs have been reported using a gate that wraps around the wire (for example., Q.T. Do et al., "High Transconductance MISFET with a Single InAs Nanowire Channel," Electron Device Letters, Vol. 28, No. 8, p. 682 (2007) and C. Thelander et al., "Vertical Enhancement-Mode InAs Nanowire Field-Effect Transistor with 50nm Wrap Gate," Electron Device Letters, Vol. 29, No. 3, p. 206 (2008)). A disadvantage of such nanowire MOSFETS is their incompatibility with standard CMOS technology due to their nonplanar structure.

The prior art also describes a process of shallow trench isolation ("STI"), which is applied early during the semiconductor device fabrication process, before transistors are formed. The key steps of the STI process involve etching a pattern of trenches in the silicon, depositing one or more dielectric materials, such as silicon dioxide, to fill the trenches, and removing the excess dielectric using a technique such as chemical-mechanical planarization ("CMP").

### SUMMARY

One embodiment is a method comprising defining a mask on a silicon substrate, the mask comprising a plurality of nano-size openings therethrough; subsequent to the defining, creating essentially defect-free non-silicon semiconductor nano-islands on portions of a surface of the silicon substrate exposed through the mask openings; subsequent to the creating, depositing high-k gate dielectric is deposited on the nano-islands; and subsequent to the deposition, constructing transistors on the nano-islands.

### BRIEF DESCRIPTION OF THE DRAWINGS

Fig. 1 illustrates a relative arrangement of a hardmask and nano-islands constructed therewith on a silicon substrate in accordance with one embodiment.

Fig. 2 illustrates a heteroepitaxial layer structure of a nano-island for an n-channel MOSFET in accordance with one embodiment.

Fig. 3A illustrates a transistor constructed over a nano-island in accordance with one embodiment.

Fig. 3B illustrates a transistor constructed over traditional materials in accordance with the prior art.

Fig. 4 illustrates a method of creating dislocation-free, thin heteroepitaxial, single crystal nano-islands on a substrate in accordance with one embodiment.

Fig. 5 illustrates a graph of historic and projected sizes for various types of logic gate cells.

### DETAILED DESCRIPTION

Aspects of the present disclosure are best understood from the following detailed description when read with the accompanying figures. It is emphasized that, in accordance with the standard practice in the industry, various features are not drawn to scale. In fact, the dimensions of the various features may be arbitrarily increased or reduced for clarity of discussion.

The embodiments described herein provide a low-defect or defect-free heteroepitaxial approach compatible with CMOS requirements, including, but not limited to, effective heat removal and planarity, as well compatibility with existing CMOS manufacturing methods at and below the 22 nm node. In particular, the embodiments described herein provide dislocation-free heteroepitaxial nano-islands of single crystal material on a silicon substrate. Transistors fabricated on the nano-islands are compatible with CMOS manufacturing requirements; in particular, the structure is planar, thin device layers allow for sufficient heat removal, and area requirements are identical to standard silicon CMOS as described in the International Technology Roadmap for Semiconductors. Additionally, the mask used to create the nano-islands on the silicon substrate is simultaneously used to electrically isolate devices from each other.

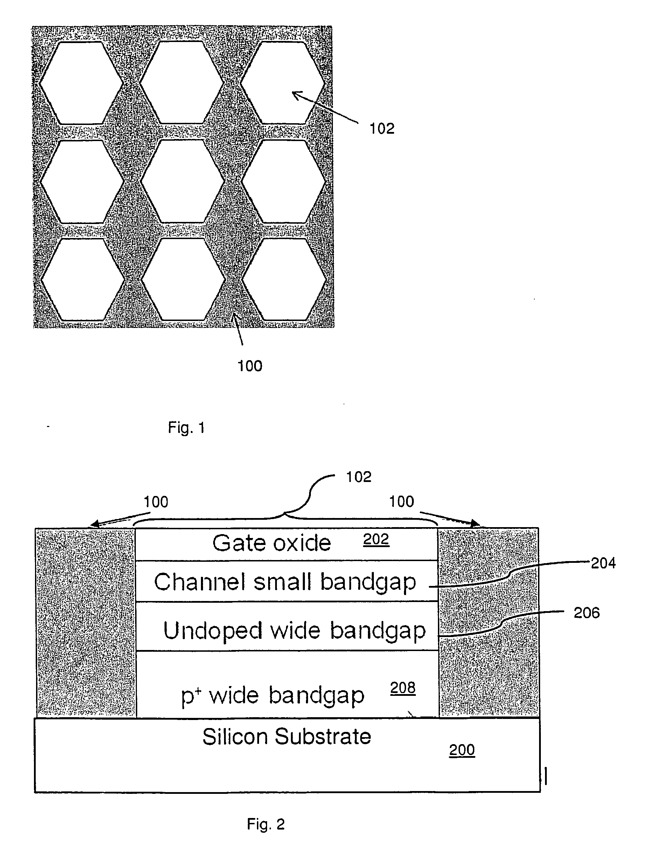

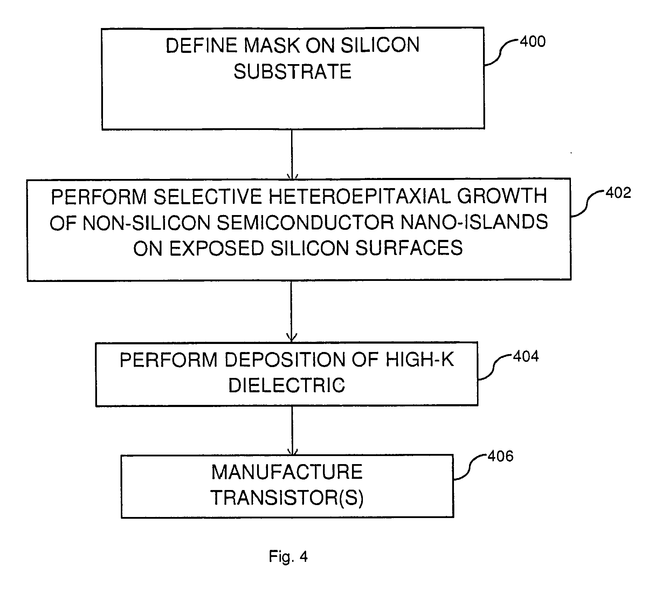

Referring now to Fig. 1, a hardmask 100, which may comprise, for example, a dielectric, is used to create dislocation-free, thin heteroepitaxial, single crystal nano-islands 102 on a silicon substrate 200 (Fig. 2), as described in connection with Fig. 4. The nano-islands 102 could be interpreted as terminated nanowires comprising only thin layers required for device functionality. In one embodiment, the total thickness of the nano-islands 102 does not exceed 50 nm. As shown in Fig. 2, the nano-islands 102 may include a number of heteroepitaxial layers as dictated by device requirements. In particular, Fig. 2 illustrates an n-channel MOSFET layer structure of a single nano-island 102, which includes a gate oxide layer 202, a channel small bandgap layer 204, an undoped wide bandgap layer 206, and a p+ wide bandgap layer 208. On each nano-island 102, one or multiple transistors can be realized, or nano-islands can be combined to form a larger transistor. The size of a nano-island 102 is similar to the typical cross-section of a nanowire and the upper limit of the size of a nano-island dictated by the limitations of dislocation-free growth.

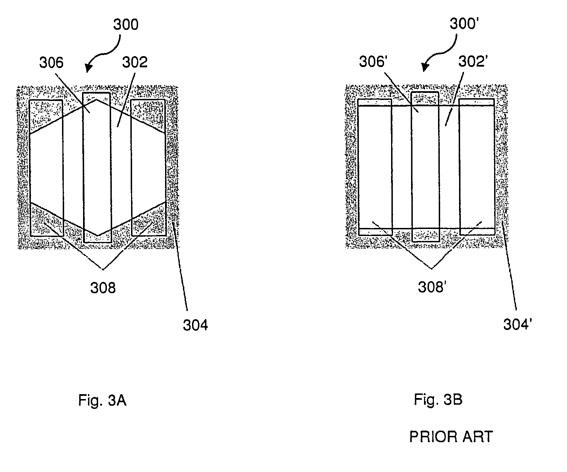

Since nanowires typically grow with a hexagonal cross-section, in one embodiment, the hardmask 100 comprises includes hexagonally-shaped openings (hence, the term "honeycomb") to facilitate dislocation-free growth. The silicon substrate 200 may further have a (111) surface orientation to facilitate dislocation-free growth. The hardmask 100 may be designed such that the area requirement of a transistor implemented using a nano-island is equivalent to a standard CMOS silicon transistor of a given node, as illustrated in Figs. 3A and 3B. In particular, Fig. 3A illustrates a transistor 300 constructed over a nano-island 302 in accordance with one embodiment. Fig. 3B illustrates a transistor 300' constructed over traditional materials, in this case, silicon 302', in accordance with the prior art. In Fig. 3A, an area 304 represents a hardmask and isolation. In Fig. 3B, an area 304' represents STI and isolation. Each of the transistors 300, 300' includes a gate 306, 306', respectively, and ohmic contacts 308, 308', respectively. As will be noted from a comparison of Figs. 3A and 3B, and as indicated above, the area of the transistor 300 is essentially equivalent to that of the transistor 300'.

Fig. 4 illustrates a flowchart of a method of creating dislocation-free, thin heteroepitaxial, single crystal nano-islands on a substrate in accordance with one embodiment. Referring to Fig. 4, in step 400, a mask is defined on a silicon substrate using, for example, thermal oxidation, oxide deposition, and/or lithography. As described in connection with Fig. 1, the mask defined in step 400 is a hardmask. In step 402, selective heteroepitaxial growth of non-silicon semiconductor nano-islands onto exposed silicon surfaces is performed, for example, via metalorganic chemical vapor deposition ("MOCVD") and/or gas source molecular beam epitaxy ("MBE"). In step 404, high-k gate dielectric is deposited, for example, via MOCVD, atomic layer deposition ("ALD"), and/or MBE. Finally, in step 406, transistors are constructed over the nano-islands by placing gates, sidewalls, and ohmic contacts thereof.

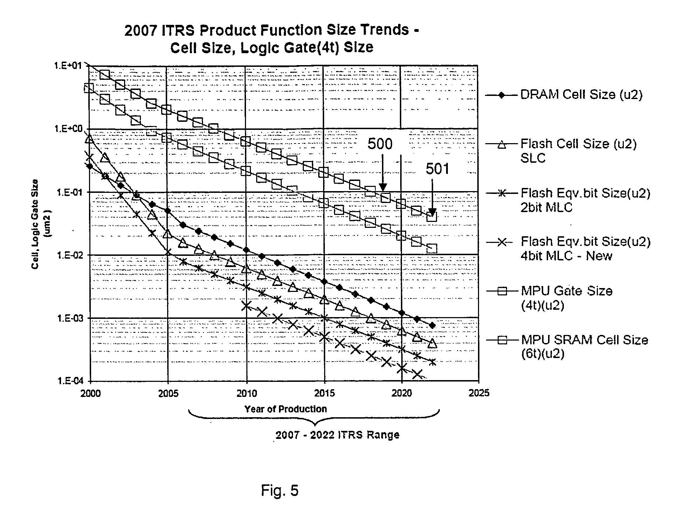

Non-silicon channel materials, such as III-V semiconductors and Ge, are considered for CMOS generations beyond 22 nm. Typical transistor area for such technologies is < 20,000 nm². Fig. 5 illustrates a graph of historic and projected sizes for MPU gate size (4 transistors). For example, the projected size for a single transistor for the 16 and 11 nm nodes (node is defined here by MPU/ASIC metal 1 (M1) ½ pitch) is about 20,000 nm² and 10,000 nm² including isolation, as indicated by points 500 and 501, respectively. This translates into edge length of 140 and 100 nm, assuming a transistor cell of square area and including isolation. Note that the nano-islands of heteroepitaxial material are still smaller since they are implemented inside the isolation mask pattern. Dislocation-free InAs nanowires on silicon substrate with such dimensions have already been demonstrated.

While the preceding shows and describes one or more embodiments, it will be understood by those skilled in the art that various changes in form and detail may be made therein without departing from the spirit and scope of the present disclosure. For example, various steps of the described methods may be executed in a different order or executed sequentially, combined, further divided, replaced with alternate steps, or removed entirely. In addition, various functions illustrated in the methods or described elsewhere in the disclosure may be combined to provide additional and/or alternate functions. Therefore, the claims should be interpreted in a broad manner, consistent with the present disclosure.

## Claims

1. A method comprising:
defining a mask on a silicon substrate, the mask comprising a plurality of nano-size openings therethrough;
subsequent to the defining, creating essentially defect-free non-silicon semiconductor nano-islands on portions of a surface of the silicon substrate exposed through the mask openings;
subsequent to the creating, depositing high-k gate dielectric on the nano-islands; and
subsequent to the deposition, constructing transistors on the nano-islands.

2. The method of claim 1 wherein the creating comprises performing selective heteroepitaxial growth of the non-silicon semiconductor nano-islands via metalorganic chemical vapor deposition ("MOCVD").

3. The method of claim 1 wherein the creating comprises performing selective heteroepitaxial growth of the non-silicon semiconductor nano-islands via gas source molecular beam epitaxy ("MBE").

4. The method of claim 1, 2 or 3, wherein the depositing is performed via MOCVD.

5. The method of claim 1, 2 or 3, wherein the depositing is performed via atomic layer deposition ("ALD").

6. The method of claim 1, 2 or 3, wherein the depositing is performed via MBE.

7. The method of claim 1, 2 , 3, 4 or 5, wherein each of the openings is hexagonally shaped.

8. The method of claim 1, 2 , 3, 4 or 5, wherein the constructing comprises placing gates, sidewalls, and Ohmic contacts.

9. A semiconductor device comprising:
a silicon substrate;
a mask disposed on a top surface of the silicon substrate and comprising a plurality of nano-size openings therethrough;
essentially defect-free non-silicon semiconductor nano-islands grown on portions of the top surface of the silicon substrate exposed through the mask openings;
high-k gate dielectric deposited on the nano-islands; and
transistors constructed on the nano-islands.

10. The device of claim 9 wherein each of the openings is hexagonally shaped.

11. The device of claim 9 wherein a thickness of the nano-island is less than or equal to 50 nm.

12. The device of claim 9 wherein the silicon substrate has a (111) surface orientation.

13. The device of claim 9 wherein the mask comprises a hardmask.
